# EUROPEAN PATENT APPLICATION

(11) **EP 4 672 906 A1**
(43) Date of publication of application: **31.12.2025**
(21) Application number: 24185408.2
(22) Date of filing: 28.06.2024
(51) Int. Cl.: H10D 64/27, H10D 30/66, H10D 30/01

(54) **A METHOD OF MANUFACTURING BOTTOM THICK OXIDE, BTO, IN A TRENCH OF A SEMICONDUCTOR MATERIAL AS WELL AS FIELD OXIDE, FOX, ON TOP OF THE SEMICONDUCTOR MATERIAL, AS WELL AS A RELATED SEMICONDUCTOR DEVICE**

(71) Applicant: Nexperia B.V., 6534 AB Nijmegen (NL)
(72) Inventor: Erlbacher, Tobias, Hamburg (DE); Schumacher, Olrik, Hamburg (DE)
(74) Representative: Pjanovic, Ilija

(57) **Abstract**

A method of manufacturing Bottom Thick Oxide, BTO (7), in a trench of a semiconductor material (4) as well as Field Oxide, FOX (6), on top of the semiconductor material, said method comprising the steps of providing a trench in said semiconductor material, such that said trench penetrates into said semiconductor material from a surface of said semiconductor material, providing a first material on said surface of said semiconductor material as well as in said provided trench, providing a mask on top of said first material at a location above said surface of said semiconductor material, said location directly relating to a location of said FOX (6), etching, with said mask provided on top of said first material, said first material on top of said surface of said semiconductor material, such that remaining first material in said trench is or results in said BTO (7).

## Description

### Technical field

The present disclosure generally relates to the field of manufacturing semiconductor devices and, more specifically, to an improved method of manufacturing a trench in said semiconductor device.

### Background

A Metal-Oxide-Semiconductor Field-Effect Transistor, MOSFET is a component in modern electronics, serving as a switch or amplifier in various devices. In semiconductor devices, particularly in power electronics, MOSFETs with gate trench structures are often employed due to their performance characteristics. A gate trench MOSFET features a vertical trench etched into the silicon substrate, extending from the surface down into the substrate and filled with gate material, typically polysilicon, insulated from the surrounding silicon by a layer of silicon dioxide, for example SiO2. This vertical design contrasts with conventional planar MOSFETs, where the gate electrode lies on the surface of the silicon wafer.

The gate trench MOSFET offers several advantages. The vertical structure allows for improved electrostatic control of the channel, reducing leakage currents and enhancing on-state performance. It also enables higher density, allowing for more compact device layouts and increasing the number of MOSFETs per unit area on the chip. Additionally, by optimizing the trench depth and gate oxide thickness, the on-resistance can be significantly reduced, improving the efficiency of power devices.

The process of creating a gate trench in a semiconductor device involves several steps, utilizing lithography, etching, and deposition techniques. It may start with substrate preparation, where a high-quality silicon wafer, typically doped to the desired type, for example n-type or p-type, and resistivity, is cleaned thoroughly to remove any contaminants. Next, a thin layer of silicon dioxide may be thermally grown on the surface of the silicon wafer. This layer serves as a protective barrier and a mask during subsequent etching processes.

Following the oxide layer formation, photolithography may be used to define the trench pattern. A photoresist layer is applied to the wafer and exposed to ultraviolet light through a photomask that defines the trench areas. The exposed photoresist is then developed, leaving behind the patterned photoresist that protects specific areas of the oxide layer. The unprotected oxide is then etched away, exposing the silicon surface where the trenches will be formed.

The next step is the trench etching, where the silicon wafer is subjected to anisotropic etching. This etching process creates vertical trenches in the silicon with well-defined profiles.

A subsequent step is the formation of a thick bottom oxide at the base of the trench. The thick bottom oxide serves to isolate the bottom of the gate from the underlying silicon, reducing parasitic capacitance and preventing unwanted current leakage. This is achieved by growing or depositing a thicker oxide layer at the trench bottom after the initial etching step.

After the trenches are etched and the bottom oxide is formed, a thin layer of silicon dioxide is grown or deposited on the trench walls to serve as the gate oxide. This step is of importance as it forms the insulating barrier between the gate electrode and the silicon substrate.

Once the gate oxide is in place, the trenches are filled with polysilicon, which serves as the gate electrode. The polysilicon is doped, for example either during deposition or with a subsequent doping step. The polysilicon is deposited by using, for example, chemical vapor deposition, CVD, and then planarized to remove any excess material above the wafer surface. A subsequent annealing step is performed to improve the polysilicon's electrical properties and to ensure good contact with the gate oxide.

In addition to the trench structure, the surface of the substrate is often covered with a Field Oxide Layer, FOX. This field oxide is typically thicker than the gate oxide and may be used to isolate the active regions of the MOSFET from each other, reducing parasitic capacitance and preventing electrical interference between adjacent devices.

The field oxide is, for silicon based semiconductors, typically formed through a process called Local Oxidation of Silicon, LOCOS, where silicon nitride is used as a mask to grow a thick oxide layer only in designated areas.

Finally, the source and drain regions of the MOSFET are formed through ion implantation, where dopants are introduced into the silicon substrate adjacent to the gate trenches. The wafer is then subjected to a high-temperature annealing process to activate the dopants and repair any damage to the silicon lattice caused by the implantation. The last steps involve forming the necessary contacts and interconnections, including the deposition of metal layers and patterning them to create the source, drain, and gate terminals.

In essence, the creation of a trench in a semiconductor material required many subsequent steps to be performed. Any of these steps may introduce complexity which is undesired.

### Summary

It would be advantageous to achieve a method of manufacturing a trench in a semiconductor material in which less, or less complex, manufacturing steps are required. It would further be advantageous to achieve a method of manufacturing a Bottom Thick Oxide, BTO, in the trench of the semiconductor material as well as the Field Oxide, FOX, on top of the semiconductor material in the same manufacturing steps as this would reduce complexity.

In a first aspect of the present disclosure, there is provided a method of manufacturing Bottom Thick Oxide, BTO, in a trench of a semiconductor material as well as Field Oxide, FOX, on top of the semiconductor material.

The method comprising the steps of:
- providing a trench in said semiconductor material, such that said trench penetrates into said semiconductor material from a surface of said semiconductor material;
- providing a first material on said surface of said semiconductor material as well as in said provided trench;
- providing a mask on top of said first material at a location above said surface of said semiconductor material, said location directly relating to a location of said FOX;
- etching, with said mask provided on top of said first material, said first material on top of said surface of said semiconductor material, such that remaining first material in said trench is or results in said BTO.

The inventors have found that it is possible to create a manufacturing process in which the BTO and the FOX are created using the same manufacturing steps.

The above described method steps thus enable the combined fabrication of the TBO and the FOX. The TBO is used to ensure gate oxide integrity in the gate dielectric of Metal Oxide Semiconductor, MOS, Field Effect Transistors, FETs, and the FOX is used to reduce gate capacitance and to ensure gate oxide integrity of the MOSFETs.

The fabrication of the TBO and the FOX in a combined process, i.e. prior to gate oxide formation, both simplified the manufacturing process, i.e. it requires less effort, and reduces the risk of manufacturing issues due to the impact of subsequential oxide layer manufacturing (like deposition, lithography and etching) on each other.

The invention is now disclosed in more detail with reference to specific examples.

In a first example, the first material comprises an oxide typically silicon dioxide. The oxide may be deposited using a plurality of techniques.

Thermal oxidation is a process that involves exposing the semiconductor material to an oxidizing environment at high temperatures, causing a layer of silicon dioxide to grow on the surface and in the trench. The resulting silicon dioxide layer is integral to the performance of the MOSFET, providing a reliable insulating barrier that may be of importance for device operation.

Chemical Vapor Deposition ,CVD, techniques, such as low-pressure CVD, LPCVD, and plasma-enhanced CVD, PECVD, may be used to deposit oxide layers with precise control over their thickness and composition. High-Density Plasma CVD,HDP-CVD, is a specialized form of CVD that utilizes a high-density plasma to enhance the deposition process.

In an example, the method comprises the step of:
- etching said first material provided on said surface of said semiconductor material such that a thickness of said first material on top of said surface is a required thickness of said FOX.

It may be beneficial to first etch the first material, being the oxide, such that a certain thickness of the oxide layer remains on the surface of the semiconductor material. This thickness is of the same thickness as the desired FOX layer. This etching step may thus be matched to the required or desired thickness of the FOX layer.

The subsequent steps of the process, like masking and additional etching, will then create the TBO and the FOX with the desired thicknesses.

In a specific example, the method comprises the step of:
- removing said mask after said step of etching said first material with said mask;
- etching said first material provided on said surface of said semiconductor material and said first material provided in said trench, such that a thickness of said first material on top of said surface is a required thickness of said FOX.

These two additional steps describe the method in a bit more detail. First, an oxide material is provided on the surface of the semiconductor material and in the trench. Basically, the trench is completely filled with the oxide material. Then, the oxide material is etched to the required thickness. The result of this etching step if that the layer of oxide material remaining on the surface of the semiconductor material equals the desired thickness of the FOX.

Then, a mask is provided on top of the oxide material at the region(s) where the FOX is needed. Then, a lithography step if performed to move the oxide material from the surface of the semiconductor material. Finally, a recess of oxide down to the TBO thickness is performed.

In a further example, the first material comprises PolySilicon, PolySi, and wherein said method further comprises a step of:
- oxidating of said PolySilicon on top of said first surface and in said trench thereby forming said BTO and FOX.

The inventors have found that it may also be beneficial to use a PolySilicon, PolySi, as the first material. If that's the case, then an additional step of oxidating the PolySi to obtain oxide materials is required. This additional step thus creates the FOX and the TBO.

In a specific example, the method further comprises the step of:
- etching said first material provided on said surface of said semiconductor material such that a thickness of said first material on top of said surface is related to a required thickness of said FOX.

It is noted that etching the first material being a PolySi may result in a thickness that is a bit smaller compared to the thickness of the FOX, as the oxidation process may add a bit of thickness to the resulting FOX and/or TBO.

In a specific example, the method comprises the steps of:
- removing said mask after said step of etching said first material with said mask;
- etching said first material provided on said surface of said semiconductor material and said first material provided in said trench, such that a thickness of said first material on top of said surface is related to a required thickness of said FOX.

In another example of the present disclosure, the step of providing said first material on said surface of said semiconductor material as well as in said provided trench comprises:
- providing a layer of PolySilicon, PolySi, on top of said surface of said semiconductor material as well as in said trench, said layer having a substantially uniform thickness;
- providing a nitride spacer at sidewalls of the provided PolySi in said trench.

It was found that the trench does not need to be completely filled with the first material. A layer of PolySi may be provided on top of the surface of the semiconductor material as well as in the trench. This would mean that the trench is not completely filled with PolySi. The sidewalls of the trench are provided with the PolySi layer and the bottom of the trench is provided with the PolySi layer.

The thickness of the PolySi layer may relate to the required thickness of the FOX. As mentioned above, the PolySi layer may undergo a process of oxidation, which process may add thickness to the resulting FOX and/or BTO. As such, the PolySi layer may have a smaller thickness compared to the desired or required thickness of the FOX and/or the BTO.

The nitride spacer is used to prevent the PolySi at the sidewalls of the trench to be involved in the oxidation process. As such, the PolySi at the sidewalls of the trench will not oxidate.

Finally, the nitride spacer and the PolySi provided at the sidewalls of the trench may be removed, after the oxidation process.

In yet another example, the method comprises the steps of:
- removing said mask after said step of etching said first material with said mask;
- oxidating of said PolySilicon on top of said first surface and in said trench thereby forming said BTO and FOX.

In a further example, the semiconductor material is any of Silicon, Silicon Carbide, SiC and Gallium Nitride, GaN.

In the fabrication of gate trench MOSFETs, the semiconductor material used can be either silicon or silicon carbide, SiC, among others. Silicon is has good electrical properties, mature processing technologies, and is cost-effectiveness.

Silicon carbide, SiC, on the other hand, is a semiconductor material that offers improved performance in high-temperature, high-voltage, and high-frequency applications. SiC devices can operate at higher temperatures and voltages than silicon devices, making them ideal for use in power electronics, such as inverters for electric vehicles, power supplies for industrial applications, and power management systems for renewable energy sources. SiC's wider bandgap, higher thermal conductivity, and higher breakdown electric field strength make it a good choice for these demanding applications.

Other semiconductor materials that are used in specific applications include gallium nitride, GaN, which has high electron mobility and efficiency in high-frequency and high-power applications. GaN may be increasingly used in RF, radio frequency, components, power amplifiers, and LED technology.

It may be beneficial to use, for example, silicon carbide. The inventors have realized that the LOCOS process of growing oxide allows for self-aligned manufacturing techniques that cannot be readily transferred to silicon carbide. That is one of the reasons why a skilled person in the field of silicon carbide would not consider the LOCOR processes as a straight-up process for FOX fabrication. Due to the low oxidation rate of SiC, the application of LOCOS has not seen adoption in SiC technology

In another example, there is provided method of manufacturing a Metal Oxide Semiconductor, MOS, Field Effect Transistor, FET, in a semiconductor material, wherein said step of manufacturing said MOSFET comprises the steps of any of the previous examples.

The inventors have found that the manufacturing of a trench, as explained in previous examples, is especially useful when manufacturing a MOSFET.

In a specific example, the trench is a gate trench of said MOSFET.

In a second aspect of the present disclosure, there is provided a semiconductor device embodied in a semiconductor material, said semiconductor device comprising Bottom Thick Oxide, BTO, in a trench of said semiconductor material as well as Field Oxide, FOX, on top of the semiconductor material, wherein said BTO and said FOX are manufactured in accordance with any of the examples as provided above.

It is noted that the advantages as explained with reference to the first aspect of the present disclosure, being the method of method of manufacturing Bottom Thick Oxide, BTO, in a trench of a semiconductor material as well as Field Oxide, FOX, on top of the semiconductor material, are also applicable to the second aspect of the present disclosure, being the semiconductor device.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

The above and other aspects of the disclosure will be apparent from and elucidated with reference to the examples described hereinafter.

### Brief description of the figures

Fig.1a-d discloses a process of manufacturing Bottom Thick Oxide, BTO, in a trench of a semiconductor material as well as Field Oxide, FOX, on top of the semiconductor material in accordance with an example of the present disclosure;
Fig. 2a-c discloses a process variant to the process disclosed in figure 1a-d;
Fig.3a-d discloses a process of manufacturing Bottom Thick Oxide, BTO, in a trench of a semiconductor material as well as Field Oxide, FOX, on top of the semiconductor material in accordance with a further example of the present disclosure;
Fig. 4a-d discloses a process variant to the process disclosed in figure 3a-d;
Fig. 5a-c discloses a process of manufacturing Bottom Thick Oxide, BTO, in a trench of a semiconductor material as well as Field Oxide, FOX, on top of the semiconductor material in accordance with yet another example of the present disclosure.

### Detailed description

It is noted that in the description of the figures, same reference numerals refer to the same of similar components performing a same of essentially similar function.

A more detailed description is made with reference to particular examples, some of which are illustrated in the appended drawings, such that the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or" in reference to a list of two or more items, covers all the following interpretations of the word: any of the items in the list, all of the items in the list, and any combination of the items in the list.

These and other changes can be made to the technology considering the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein.

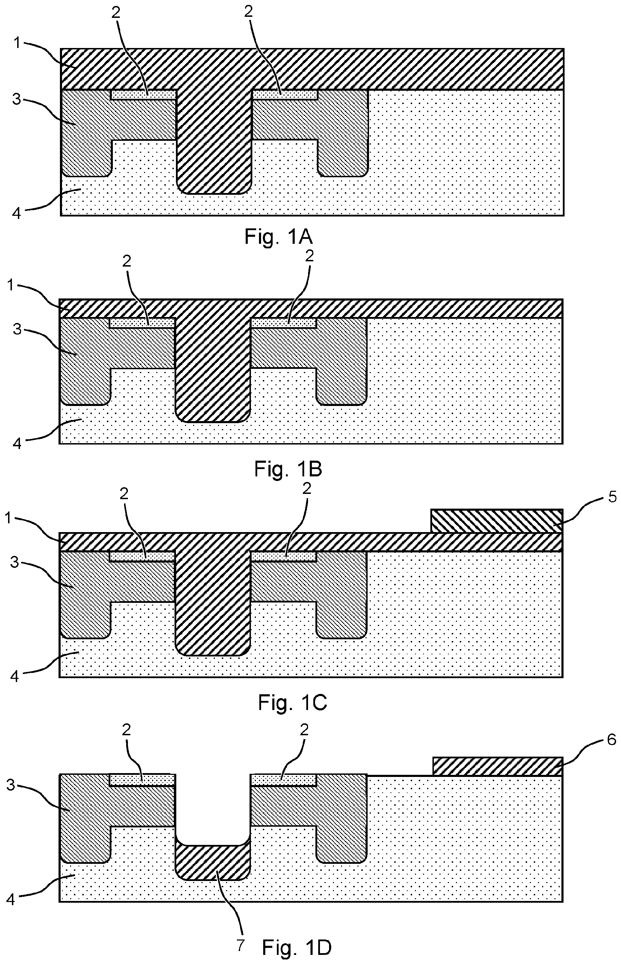

Fig.1a-d discloses a process of manufacturing Bottom Thick Oxide, BTO, in a trench of a semiconductor material as well as Field Oxide, FOX, on top of the semiconductor material in accordance with an example of the present disclosure.

Figure 1a discloses a starting point of the present disclosure. Here, a trench is shown provided in the semiconductor material. An oxide is provided on top of the surface as well as in the trench. The trench is completely filled with the oxide.

Figure 1b shows that the oxide is etched to a particular thickness. This thickness matches, or relates, to the desired thickness of the FOX.

Figure 1c shows that a mask is provided on top of the oxide at the surface of the semiconductor material. This mask is provided on regions at the oxide where the FOX is to be created.

The oxide may then be etched, at the surface of the semiconductor material.

Figure 1d discloses that the trench may be etched to a particular depth, such that the TBO remains in the trench.

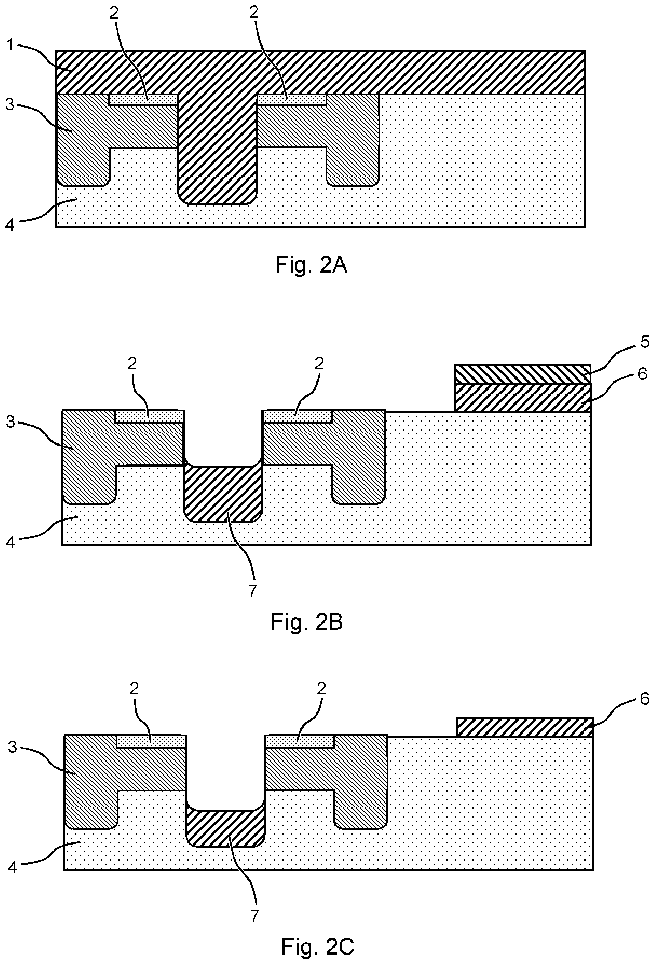

Figures 2a - 2c relate to the process as disclosed in figures 1a - 1d and is briefly discussed in the following.

Figure 2a shows the same starting point as disclosed in figure 1a.

In stead of etching the oxide to the required thickness, the example shown in figure 2 first places a mask at the location where the FOX is to be created. This means that the oxide is still thicker than the required thickness of the FOX. Then, as shown in figure 2b, an etching process is performed to remove the oxide present on the surface of the semiconductor material. Of course, the oxide underneath the mask is not removed as that is why a mask is used. Finally, as shown in figure 2c, the remaining oxide on the surface of the semiconductor material may be recessed as well as the oxide present in the trench, to create the desired thicknesses for the TBO and the FOX.

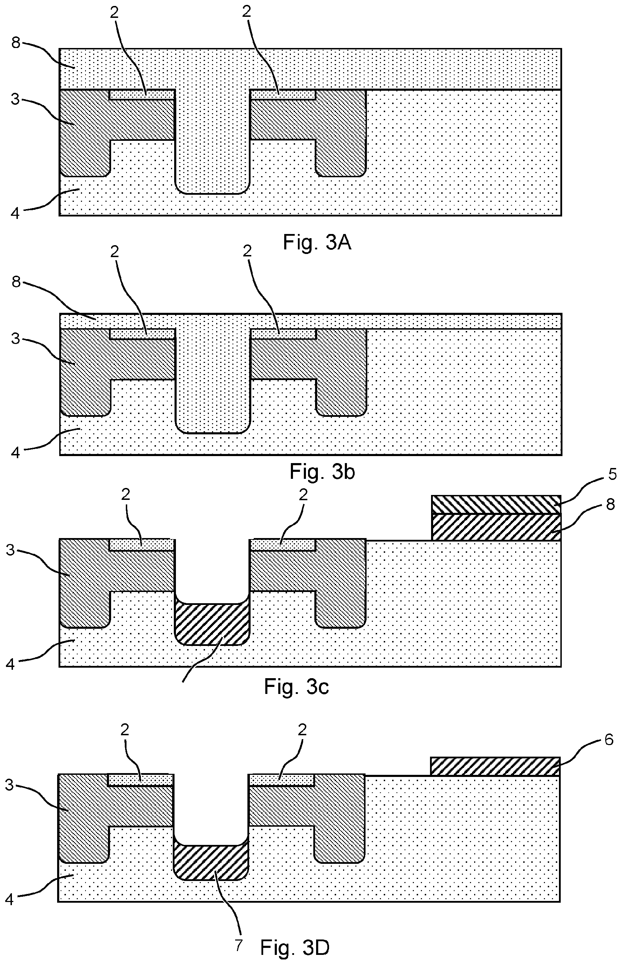

Fig.3a-d discloses a process of manufacturing Bottom Thick Oxide, BTO, in a trench of a semiconductor material as well as Field Oxide, FOX, on top of the semiconductor material in accordance with a further example of the present disclosure.

In this particular case, the first material is a PolySi material. The steps shown in figures 3a - 3c resemble the steps as shown in figures 1a-1c. However, in figure 3d an additional step is shown, which is oxidating the PolySi to create the oxide for the FOX and the TBO.

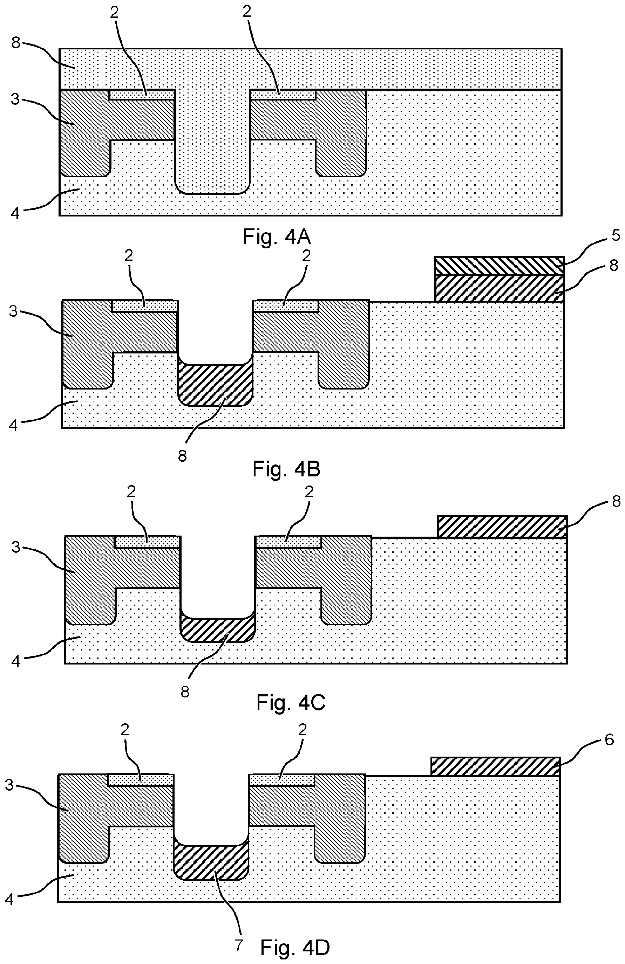

Fig. 4a-c discloses a process variant to the process disclosed in figure 3a-d. The steps shown in figures 4a-4c are similar to the steps shown in figures 1a-1c. The additional step 4d is similar to the step shown in figure 3d.

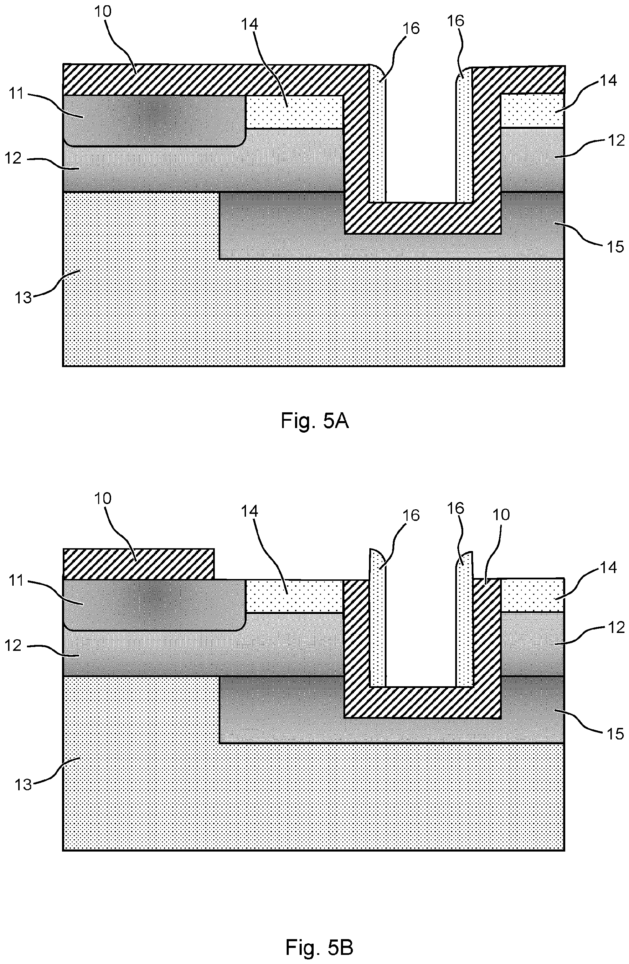

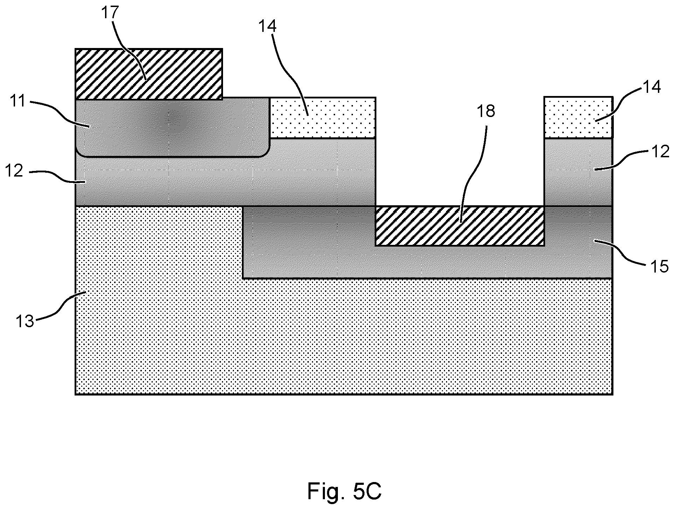

Fig. 5a-c discloses a process of manufacturing Bottom Thick Oxide, BTO, in a trench of a semiconductor material as well as Field Oxide, FOX, on top of the semiconductor material in accordance with yet another example of the present disclosure.

The difference in this example compared to the previous examples is that a thin layer of PolySi is provided in stead of completely filling the trench. This requires an additional step of providing a nitride spacer to the sidewalls of the trench, for preventing the polysilicon provided at the sidewalls of the trench to get oxidated during the oxidation process.

As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms. Accordingly, the actual scope of the technology encompasses not only the disclosed examples, but also all equivalent ways of practicing or implementing the technology under the claims.

### REFERENCE LIST

- 1: Oxide
- 2: Semiconductor material
- 3: Semiconductor material
- 4: Semiconductor material
- 5: Resist
- 6: FOX
- 7: BOX
- 8: PolySilicon
- 10: PolySilicon
- 11: p+
- 12: p-well
- 13: Semiconductor material
- 14: n+
- 15: n-CSL
- 16: SixNy

## Claims

1. A method of manufacturing Bottom Thick Oxide, BTO, in a trench of a semiconductor material as well as Field Oxide, FOX, on top of the semiconductor material, said method comprising the steps of:
- providing a trench in said semiconductor material, such that said trench penetrates into said semiconductor material from a surface of said semiconductor material;
- providing a first material on said surface of said semiconductor material as well as in said provided trench;
- providing a mask on top of said first material at a location above said surface of said semiconductor material, said location directly relating to a location of said FOX;
- etching, with said mask provided on top of said first material, said first material on top of said surface of said semiconductor material, such that remaining first material in said trench is or results in said BTO.

2. A method in accordance with claim 1, wherein said first material comprises an oxide.

3. A method in accordance with any of the previous claims, wherein said step method further comprises the step of:
- etching said first material provided on said surface of said semiconductor material such that a thickness of said first material on top of said surface is a required thickness of said FOX.

4. A method in accordance with any of the claims 1 - 2, wherein said method comprises the step of:
- removing said mask after said step of etching said first material with said mask;
- etching said first material provided on said surface of said semiconductor material and said first material provided in said trench, such that a thickness of said first material on top of said surface is a required thickness of said FOX.

5. A method in accordance with claim 1, wherein said first material comprises PolySilicon, PolySi, and wherein said method further comprises a step of:
- oxidating of said PolySilicon on top of said first surface and in said trench thereby forming said BTO and FOX.

6. A method in accordance with claim 5, wherein said method further comprises the step of:
- etching said first material provided on said surface of said semiconductor material such that a thickness of said first material on top of said surface is related to a required thickness of said FOX.

7. A method in accordance with claim 5, wherein said method comprises the steps of:
- removing said mask after said step of etching said first material with said mask;
- etching said first material provided on said surface of said semiconductor material and said first material provided in said trench, such that a thickness of said first material on top of said surface is related to a required thickness of said FOX.

8. A method in accordance with claim 1, wherein said step of providing said first material on said surface of said semiconductor material as well as in said provided trench comprises:
- providing a layer of PolySilicon, PolySi, on top of said surface of said semiconductor material as well as in said trench, said layer having a substantially uniform thickness;
- providing a nitride spacer at sidewalls of the provided PolySi in said trench.

9. A method in accordance with claim 8, wherein a thickness of said layer of PolySi is related to a required thickness of said FOX.

10. A method in accordance with any of the claims 8-9, wherein said method further comprises the step of:
- removing said nitride spacer and said PolySi provided at the sidewalls of the trench.

11. A method in accordance with any of the claim 10, wherein said method comprises the steps of:
- removing said mask after said step of etching said first material with said mask;
- oxidating of said PolySilicon on top of said first surface and in said trench thereby forming said BTO and FOX.

12. A method in accordance with any of the previous claims, wherein said semiconductor material is any of Silicon, Silicon Carbide, SiC and Gallium Nitride, GaN.

13. A method of manufacturing a Metal Oxide Semiconductor, MOS, Field Effect Transistor, FET, in a semiconductor material, wherein said step of manufacturing said MOSFET comprises the steps of any of the previous claims.

14. A method in accordance with claim 13, wherein said trench is a gate trench of said MOSFET.

15. A semiconductor device embodied in a semiconductor material, said semiconductor device comprising Bottom Thick Oxide, BTO, in a trench of said semiconductor material as well as Field Oxide, FOX, on top of the semiconductor material, wherein said BTO and said FOX are manufactured in accordance with any of the claims 1 - 12.
